# EUROPÄISCHE PATENTSCHRIFT

(11) **EP 1 815 728 B1**
(45) Veröffentlichungstag und Bekanntmachung des Hinweises auf die Patenterteilung: **04.01.2012**
(21) Anmeldenummer: 05807864.3
(22) Anmeldetag: 11.11.2005
(51) Int. Cl.: H05K 7/14

(54) **MODULARES AUTOMATISIERUNGSSYSTEM**
MODULAR AUTOMATION SYSTEM
SYSTEME D'AUTOMATISATION MODULAIRE

(30) Priorität: 22.11.2004 DE 102004056243
(43) Veröffentlichungstag der Anmeldung: 08.08.2007
(73) Patentinhaber: ABB AG, 68128 Mannheim (DE)
(72) Erfinder: GAUB, Gernot, 68766 Hockenheim (DE); HARTER, Egon, 77761 Schiltach (DE); GUTERMUTH, Stefan, 64653 Lorsch (DE)
(86) Internationale Anmeldenummer: PCT/EP2005/012120
(87) Internationale Veröffentlichungsnummer: WO 2006/056327

(56) Entgegenhaltungen:
- EP-A- 0 499 675
- DE-A1- 3 633 785
- US-A1- 2004 024 939
- US-B1- 6 452 785

## Beschreibung

Die Erfindung bezieht sich auf ein modulares Automatisierungssystem, das im Bereich der industriellen Automatisierungstechnik und auch im Bereich der Schalt- und Steuerungstechnik einsetzbar ist.

Marktübliche oder in Patentdokumenten beschriebene Automatisierungssysteme oder - Geräte sind häufig als modular aufgebaut, flexibel einsetzbar oder erweiterbar bezeichnet, wobei jedoch bezüglich dieser Eigenschaften mehr oder weniger große Beschränkungen gegeben sind. Beispielsweise ist aus EP 0499675 B1 ein flexibles Automatisierungssystem bekannt, das in einer ersten Ausbaustufe allein ein Kompaktgerät aufweist. In einer zweiten Ausbaustufe ist eine Erweiterung mittels Erweiterungsmodulen möglich. Falls in einer dritten Ausbaustufe eine höhere Verarbeitungsleistung benötigt wird, muss das gesamte Kompaktgerät ersetzt werden. Lediglich vorher hinzugefügte. Erweiterungsmodule sind weiter verwendbar. Die Erweiterungsmodule sind untereinander und mit dem neuen Zentralgerät mittels mehradrigen Flachbandkabeln verbunden.

Der Erfindung liegt daher die Aufgabe zugrunde, ein Automatisierungssystem anzugeben, das eine erhöhte Modularität und Erweiterbarkeit aufweist.

Diese Aufgabe wird durch ein Automatisierungssystem mit den im Anspruch 1 angegebenen Merkmalen gelöst. Vorteilhafte Ausgestaltungen sind in weiteren Ansprüchen angegeben.

Mit der Erfindung wird demnach ein Automatisierungssystem vorgeschlagen, bei dem ein zentrales Automatisierungsgerät unter Einsatz einer von mehreren wählbaren, unterschiedlich ausbaufähigen Grundplatten auf- und ausbaubar ist. Das Automatisierungsgerät ist unter Einsatz einer von mehreren Zentraleinheiten ausbaufähig, die bei einheitlichen äußeren Abmessungen eine unterschiedliche Datenverarbeitungsleistung und Datenspeicherkapazität aufweisen. An die Zentraleinheit ist wenigstens ein Einausgabegerät direkt ankoppelbar, die Zentraleinheit ist aber auch ohne Einausgabegerät arbeitsfähig. Die Grundplatten sind mit wenigstens einem Kommunikationskoppler für eine Feldbus-Verbindung zu einer dezentralen Einausgabeeinheit bestückbar.

Das erfindungsgemäße Automatisierungssystem hat eine Reihe von Vorteilen:
- Es ist bereits in der Grundausstattung des zentralen Automatisierungsgeräts ein Feldbusanschluss vorhanden, der einen Anschluss von peripheren Geräten über unterschiedliche Standard-Feldbusse, wie Profibus-DP, Modbus u. a. ermöglicht.
- Es ist ohne einen erhöhten Platzbedarf eine Erhöhung der Verarbeitungsleistung und Speicherkapazität möglich.
- Montage und Geräte-Austausch sind schnell und einfach möglich, da ein zentrales oder eigenständiges Automatisierungsgerät mittels einer Grundplatte und einer darauf aufgesteckten Zentraleinheit und gegebenenfalls Kommunikationskopplern, sowie angesteckten Einausgabe-Erweiterungsgeräten gebildet werden. Alle diese Systemkomponenten sind ohne eine Kabelverbindung elektrisch miteinander verbunden. Auch dezentrale Einausgabeeinheiten sind in ähnlicher Weise aufgebaut, nämlich mittels sogenannter Klemmenblöcken, auf die EA-Interfacemodule und EA-Erweiterungsmodule aufsteckbar sind. Mehrere EA-Erweiterungsgeräte können aneinander gereiht werden, wobei jeweils über seitliche Steckverbindungen ein Erweiterungsbus von einem Gerät zum nächsten Gerät weitergeführt wird. Innerhalb des Automatisierungssystems werden somit lediglich bei dezentralisierter Einausgabe Leitungen eines Standard-Feldbusses benötigt.
- Eine einfache Montage ist auch dadurch gegeben, dass die Geräte auf eine Hutschiene aufschnappbar sind und beim Zusammenschieben mittels seitlicher Rasteinrichtungen miteinander verbunden werden. Die Zentraleinheit, Kommunikationskoppler und EA-Module werden einfach auf eine Grundplatte oder Klemmenblöcke aufgesteckt.
- Einausgabegeräte des zentralen Automatisierungsgeräts und der dezentralen Einausgabeeinheiten sind einheitlich und unabhängig vom eingesetzten Typ der verfügbaren Zentraleinheiten gestaltet. Eine hohe Weiterverwendbarkeit von Modulen ist u. a. dadurch bei einer Änderung des Systemausbaues gegeben.

Eine weitere Erläuterung der Erfindung und deren Vorteile ergibt sich aus der nachstehenden Beschreibung eines Ausführungsbeispiels anhand von Zeichnungsfiguren.

Es zeigen:
- Fig. 1: eine Übersicht über einige typische Module und Automatisierungsgerät-Konfigurationen des Automatisierungssystems,
- Fig. 2: eine mögliche Systemkonfiguration mit Feldbus,
- Fig. 3: ein zentrales Automatisierungsgerät,
- Fig. 4 und 5: ein Einausgabegerät, und
- Fig.6: Klemmblöcke für Einausgabegeräte und Erweiterungsgeräte.

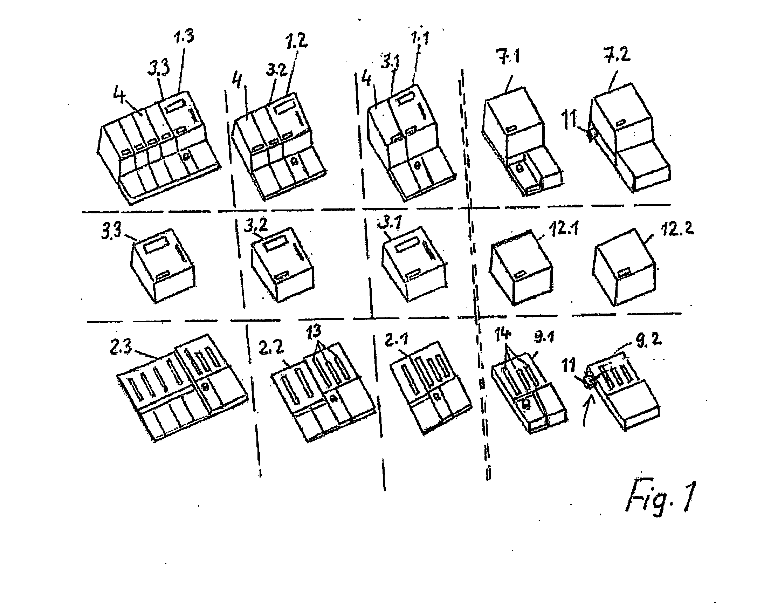

Fig. 1 zeigt in einer schematisierten und vereinfachten Darstellung in einem linken Bereich in der unteren Reihe drei beispielhafte Grundplatten 2.1, 2.2, 2.3 für den Aufbau eines zentralen Automatisierungsgeräts 1.1, 1.2, 1.3, wie links in der oberen Reihe dargestellt ist. Die kleinste Grundplatte 2.1 ist für einen geplanten Endausbau mit einer der in der mittleren Reihe dargestellten Zentraleinheiten (CPU) 3.1, 3.2, 3.3 und einem Kommunikationskoppler 4 geeignet. Die mittlere Grundplatte 2.2 ermöglicht den Ausbau mit zwei Kommunikationskopplern 4, die größte Grundplatte 2.3 den Ausbau mit vier Kommunikationskopplern 4. Jede der Grundplatten 2.1, 2.2, 2.3 kann mit jeder der Zentraleinheiten 3.1, 3.2, 3.3 bestückt werden, die sich nicht in den äußeren Abmessungen, jedoch bezüglich ihrer Verarbeitungsleistung und Speicherkapazität unterscheiden. Jede der Grundplatten 2.1, 2.2, 2.3 ist dazu mit mehrpoligen DIN-Steckern 13 versehen.

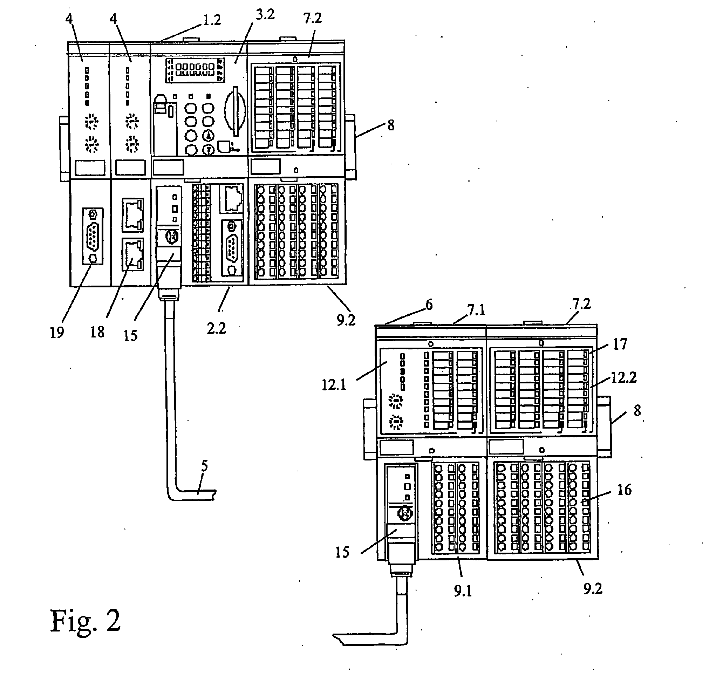

In einem rechten Bereich der Fig.1 sind in einer unteren Reihe zwei als Basisplatten verwendete EA-Klemmenblöcke 9.1, 9.2 für den Aufbau eines Einausgabegerätes 7.1 bzw. eines Einausgabe-Erweiterungsgerätes 7.2 dargestellt. EA-Klemmenblöcke 9.1 für Einausgabegeräte 7.1 weisen einen Feldbusanschluss 10 zur Verbindung mit einem der zentralen Automatisierungsgeräte 1.1 - 1.3 auf. EA-Klemmenblöcke 9.2 für Einausgabe-Erweiterungsgeräte 7.2 haben dagegen seitlich einen Steckanschluss 11 zur Verbindung mit einem Einausgabegerät 7.1 oder einem der zentralen Automatisierungsgeräte 1.1 - 1.3, wie anhand der Fig. 2 noch weiter erläutert wird. Für den Aufbau eines Einausgabegerätes 7.1 oder eines Einausgabe-Erweiterungsgerätes 7.2 wird ein auf den jeweiligen EA-Klemmenblock 9.1 bzw. 9.2 auf dessen mehrpolige DIN-Stecker 14 aufsteckbares EA-Modul 12.1 bzw. 12.2 benötigt. Klemmenblöcke 9.1, 9.2 können in unterschiedlicher Ausführung, z. B. mit Schraub- oder Federklemmen und für unterschiedliche Betriebsspannungen zur Verfügung gestellt werden. Auch EA-Module 12.1 bzw. 12.2 sind in unterschiedlicher Ausführung, z. B. als digitales oder analoges EA-Modul einsetzbar.

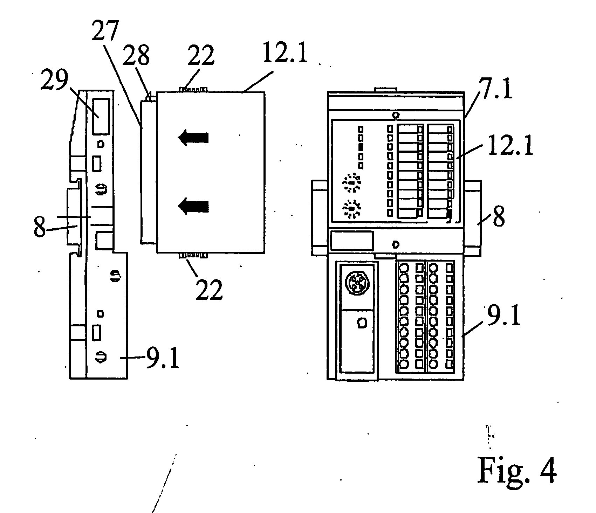

Fig. 2 zeigt beispielhaft, ein mit einer Auswahl der in Fig. 1 gezeigten Modulen konfiguriertes Automatisierungssystem. Dabei ist ein Automatisierungsgerät 1.2 eingesetzt, dessen Module auf eine Norm-Hutschiene 8 aufgeschnappt sind. Es ist eine Grundplatte 2.2 verwendet, die mit einer Zentraleinheit 3.2 bestückt ist, sowie zwei Kommunikationskoppler 4. Außerdem ist an die Grundplatte 2.2 ein EA-Klemmenblock 9.2 angesteckt, auf den wiederum ein EA-Erweiterungsmodul 12.2 aufgesteckt ist. Diese Steckmöglichkeiten sind weiter unten anhand der Darstellungen in den Figuren 4 bis 6 weiter erläutert. Die beiden Kommunikationskoppler 4 sind bezüglich ihrer Anschlüsse unterschiedlich ausgeführt, nämlich mit Ethernet Anschlüssen 18 bzw. einem 9-poligen seriellen Anschluss 19.

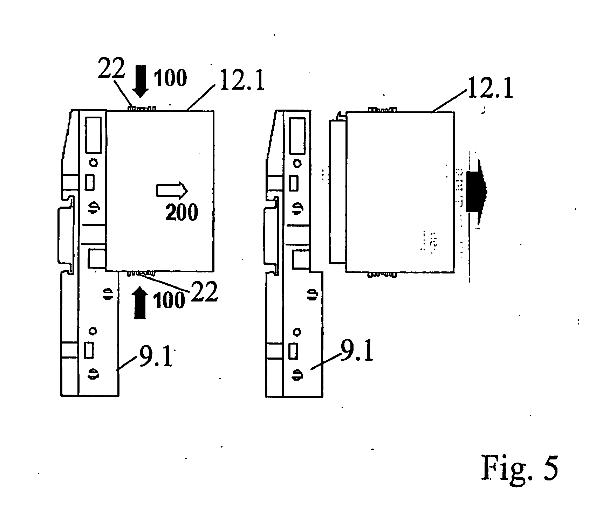

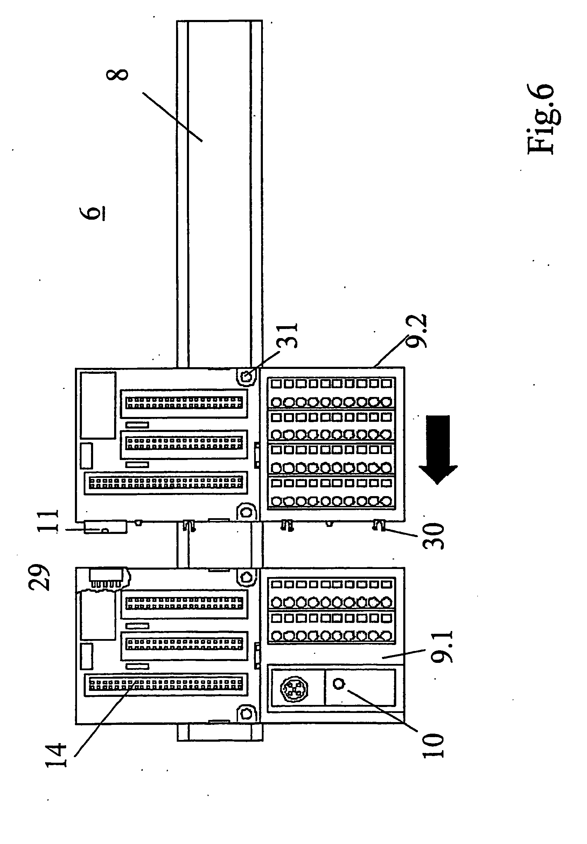

Mittels jeweils einem Feldbusstecker 15 und einer Feldbusverbindung 5 ist eine dezentrale Einausgabeeinheit 6 mit dem Automatisierungsgerät 1.2 verbunden. Die Einausgabeeinheit 6 enthält einen EA-Klemmenblock 9.1 mit einem aufgesteckten EA-Interfacemodul 12.1, also ein Einausgabegerät 7.1, sowie einen EA-Klemmenblock 9.2 mit einem aufgesteckten EA-Erweiterungsmodul 12.2, also ein Einausgabe-Erweiterungsgerät 7.2, wobei die Klemmenblöcke 9.1, 9.2 zusammengesteckt sind, wie in Fig. 6 gezeigt ist. Das Aufstecken eines Moduls auf einen Klemmenblock ist anhand der Figuren 4 und 5 verdeutlicht. Einausgabegeräte 7.1 bzw. Einausgabe-Erweiterungsgeräte 7.2 weisen jeweils einen Klemmenbereich 16 und einen Anzeigebereich 17 auf. Der Klemmenbereich 16 enthält sowohl Schraub- als auch Federzugklemmen. An Einausgabe-Erweiterungsgeräte 7.2 sind weitere Einausgabe-Erweiterungsgeräte 7.2 ansteckbar. Einausgabe-Erweiterungsgeräte 7.2 des Automatisierungsgeräts 1.2 und der Einausgabeeinheit 6 sind einheitlich ausgeführt, wodurch ein flexibler Einsatz und eine Verringerung der Typenvielfalt gegeben sind. Der Aufbau der EA-Geräte mittels einer Kombination von Klemmenblock und aufgestecktem EA-Modul hat u. a. den Vorteil, dass ein Austausch von EA-Modulen möglich ist, ohne dazu die Verdrahtung am Klemmenblock lösen zu müssen.

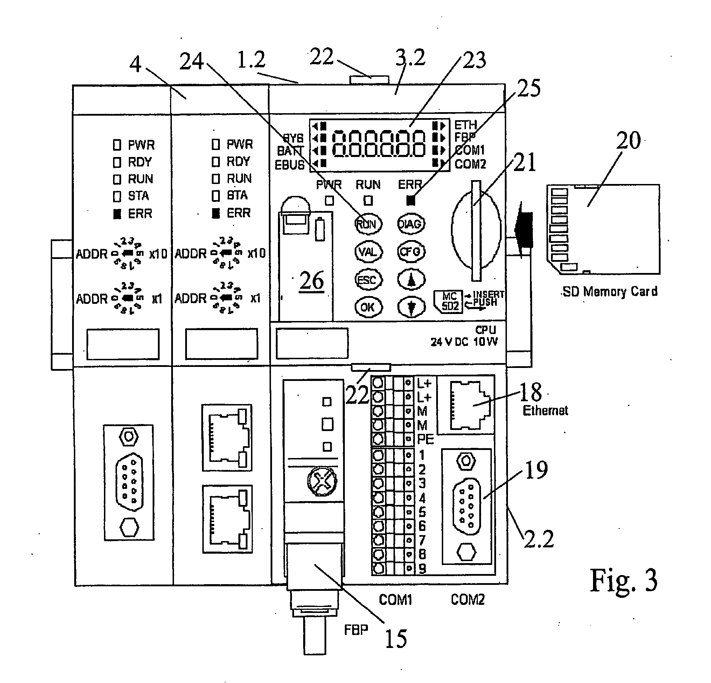

Fig. 3 zeigt nochmals das bereits in Fig. 2 dargestellte Automatisierungsgerät 1.2, wobei jedoch das Einausgabegerät 7.2 entfernt ist, um eine Datenspeicherkarte 20 darzustellen, die in einen Speicherkartenhalter 21 der Zentraleinheit 3.2 einsteckbar ist. Die Zentraleinheit 3.2 ist mit Entriegelungsmitteln 22 versehen, nach deren Betätigung die Zentraleinheit 3.2 von der Grundplatte 2.2 abgezogen werden kann. Eine hintergrundbeleuchtete LCD-Anzeige 23 ist für unterschiedliche Meldungen vorhanden, LED-Anzeigen 25 sind für direkte Statusanzeigen und mehrere Tasten 24 für Einstellungen angeordnet. Mit 26 ist die Abdeckung eines Batteriefachs bezeichnet.

Ein solches modulares Automatisierungsgerät mit Zentraleinheit und mehreren Kommunikationskopplem kann flexibel in unterschiedlicher Funktion eingesetzt werden, z. B. als Busmaster eines größeren Automatisierungssystems, als dezentrale Verarbeitungseinrichtung in einem solchen dezentralisierten größeren Automatisierungssystem, oder als stand-alone Automatisierungsgerät in Verbindung mit den lokal ankoppelbaren Einausgabegeräten, bzw. als zentrales Automatisierungsgerät eines hier anhand der Fig. 2 beschriebenen Systems.

Fig. 4 zeigt auf der rechten Seite die bereits in Fig. 2 dargestellte Frontansicht eines Einausgabegeräts 7.1, bestehend aus Klemmenblock 9.1 mit aufgestecktem EA-Interfacemodul 12.1. Links daneben ist eine Seitenansicht des Klemmenblocks 9.1 und des noch nicht aufgesteckten EA-Interfacemoduls 12.1 dargestellt. Beim Aufstecken des EA-Interfacemoduls 12.1 in Pfeilrichtung rastet dieses mittels Rastelementen 28 im Klemmenblock 9.1 ein. Außerdem wird dabei eine elektrische Verbindung durch Steckleisten 27 am EA-Interfacemodul 12.1 sowie - in Fig. 1 gezeigten - mehrpoligen DIN-Steckern 14 am EA-Interfacemodul 12.1 hergestellt. Mit 29 ist eine Erweiterungsbus-Steckbuchse 29 bezeichnet.

Fig. 5 zeigt, wie das EA-Interfacemodul 12.1 durch gleichzeitigen Druck auf die Entriegelungsmittel 22 (so auch bei der Zentraleinheit 3.2, vergl. Fig. 3) in Richtung der Pfeile 100 und Ziehen in Richtung des Pfeils 200 entfernt werden kann.

Fig. 6 zeigt Klemmenblöcke 9.1 und 9.2 einer Einausgabeeinheit 6. Aus der Darstellung ist ersichtlich, dass die Klemmenblöcke 9.1 und 9.2 durch Verschieben auf der Norm-Hutschiene 8 in Pfeilrichtung zusammensteckbar sind, und diese mittels Klemmenblock-Rastelementen 30 verrasten. Außerdem wird über den Steckanschluss 11 des Klemmenblocks 9.2 und die Erweiterungsbus-Steckbuchse 29 des Klemmenblocks 9.1 eine elektrische Steckverbindung für einen Erweiterungsbus hergestellt, der eine Erweiterung des Feldbusses darstellt, dessen Feldbusstecker am Feldbusanschluss 10 anschließbar ist. Die Klemmenblöcke 9.1 und 9.2 enthalten für den Erweiterungsbus erforderliche elektronische Einrichtungen. Der Klemmenblock 9.2 für Einausgabe-Erweiterungsgeräte enthält wie der Klemmenblock 9.1 des Einausgabegeräts 7.1 (vergl. Fig. 4) eine - in Fig. 6 nicht am Block 9.2 dargestellte - Erweiterungsbus-Steckbuchse 29, womit eine Weiterführung des Erweiterungsbusses zu weiteren Einausgabe-Erweiterungsgeräten ermöglicht ist. Öffnungen 31 an den Klemmenblöcken 9.1 und 9.2 ermöglichen deren Schraubmontage auf eine Wand, falls keine Hutschiene verwendet wird.

### Bezugszeichenliste

- 1.1, 1.2, 1.3: Automatisierungsgerät
- 2.1, 2.2, 2.3: Grundplatte
- 3.1, 3.2, 3.3: Zentraleinheit
- 4: Kommunikationskoppler
- 5: Feldbusverbindung
- 6: Einausgabeeinheit
- 7.1: Einausgabegerät mit FBP-Interface
- 7.2: Einausgabe-Erweiterungsgerät
- 8: Norm-Hutschiene
- 9.1: Klemmenblock für Einausgabegerät
- 9.2: Klemmenblock für Einausgabe-Erweiterungsgerät
- 10: Feldbusanschluss
- 11: Steckanschluss
- 12.1: aufsteckbares EA-Interfacemodul
- 12.2: aufsteckbares EA-Erweiterungsmodul
- 13: mehrpolige DIN-Stecker für Zentraleinheit
- 14: mehrpolige DIN-Stecker für EA-Modul
- 15: Feldbusstecker
- 16: Klemmenbereich
- 17: Anzeigenbereich
- 18: Ethernet-Anschluss
- 19: 9-poliger serieller Anschluss
- 20: Datenspeicherkarte
- 21: Speicherkartenhalter
- 22: Entriegelungsmittel
- 23: LCD-Anzeige
- 24: Tasten
- 25: LED-Anzeige
- 26: Abdeckung eines Batteriefachs
- 27: Steckleisten
- 28: Rastelement
- 29: Erweiterungsbus-Steckbuchse
- 30: Klemmenblock-Rastelement
- 31: Öffnung

## Patentansprüche

1. Modulares Automatisierungssystem, wobei
a) ein zentrales Automatisierungsgerät (1.1, 1.2, 1.3) unter Einsatz einer von mehreren wählbaren, unterschiedlich ausbaufähigen Grundplatten (2.1, 2.2, 2.3) aufgebaut ist,
b) das Automatisierungsgerät (1.1, 1.2, 1.3) unter Einsatz einer von mehreren Zentraleinheiten (3.1, 3.2, 3.3), die bei einheitlichen äußeren Abmessungen eine unterschiedliche Datenverarbeitungsleistung und Datenspeicherkapazität aufweisen, ausgebaut ist,
c) an die Zentraleinheit (3.1, 3.2, 3.3), wenigstens ein Einausgabe-Erweiterungsgerät (7.2) direkt angekoppelt ist, und
d) jede der Grundplatten (2.1, 2.2, 2.3) einen Feldbusanschluss (10) für eine Standard-Feldbusverbindung (5) zu einer dezentralen Einausgabeeinheit (6) hat, **dadurch gekennzeichnet, dass**
die Zentraleinheit (3.1, 3.2, 3.3) und das wenigstens ein Einausgabe-Erweiterungsgerät (7.2), ohne eine Kabelverbindung kabellos über Steckverbindungen elektrisch verbunden sind, und
dass das wenigstens eine Einausgabe-Erweiterungsgerät (7.2) der dezentralen Einausgabeeinheit (6) jeweils einen Klemmenblock (9.1, 9.2) aufweist, auf den jeweils ein EA-Modul (12.1, 12.2) aufgesteckt ist.

2. Automatisierungssystem nach Anspruch 1, **dadurch gekennzeichnet, dass** die jeweilige Grundplatte (2.1, 2.2, 2.3) des zentralen Automatisierungsgeräts (1.1, 1.2, 1.3) auf eine Norm-Hutschiene (8) aufschnappbar ist, wobei das wenigstens eine Einausgabegerät (7.2) ebenfalls auf die Hutschiene (8) aufschnappbar und mit der jeweiligen Grundplatte (2.1, 2.2, 2.3) elektrisch und mechanisch zusammensteckbar ist

3. Automatisierungssystem nach einem der vorstehenden Ansprüche, **dadurch gekennzeichnet, dass** jede Grundplatte (2.1, 2.2, 2.3) mit wenigstens einem Kommunikationskoppler (4) für Busverbindungen bestückbar ist.

4. Automatisierungssystem nach einem der vorstehenden Ansprüche, **dadurch gekennzeichnet, dass** dezentrale Einausgabeeinheiten (6) jeweils ein Einausgabegerät (7.1) mit einem Feldbusanschluss (10) aufweisen, wobei an das Einausgabegerät (7.1) mindestens ein Einausgabe-Erweiterungsgerät (7.2) anschließbar ist.

5. Automatisierungssystem nach Anspruch 4 **dadurch gekennzeichnet, dass** das Einausgabegerät (7.1) mit einem Einausgabe-Erweiterungsgerät (7.2), sowie Einausgabe-Erweiterungsgeräte (7.2) untereinander mittels Steckverbindungen (11, 29) zur Weiterleitung von Signalen eines Erweiterungsbusses verbunden sind.

6. Automatisierungssystem nach einem der vorstehenden Ansprüche, **dadurch gekennzeichnet, dass** alle Komponenten (2.1, 2.2, 2.3, 3.1, 3.2, 3.3, 4, 7.2) eines zentralen Automatisierungsgerätes (1.1, 1.2, 1.3) sowie alle Komponenten (7.1, 7.2, 9.1, 9.2, 12.1, 12.2) einer Einausgabeeinheit (6) untereinander kabellos über Steckverbindungen elektrisch verbindbar oder verbunden sind.

7. Automatisierungssystem nach Anspruch 6, **dadurch gekennzeichnet, dass** die Komponenten (2.1, 2.2, 2.3, 3.1, 3.2, 3.3, 4, 7.2) des jeweiligen Automatisierungsgerätes (1.1, 1.2, 1.3) sowie die Komponenten (7.1, 7.2, 9.1, 9.2, 12.1, 12.2) der Einausgabeeinheit (6) außerdem jeweils mittels Steck- und/oder Rastmittel (11, 13, 14, 29, 28, 30) lösbar miteinander verbindbar oder verbunden sind.

## Claims

1. Modular automation system, wherein
a) a central automation device (1.1, 1.2, 1.3) is constructed using one of a plurality of selectable and variously upgradable baseboards (2.1, 2.2, 2.3),
b) the automation device (1.1, 1.2, 1.3) is upgraded using one of a plurality of central units (3.1, 3.2, 3.3) which have uniform external dimensions yet differing data processing power and data storage capacities,
c) at least one input/output expansion device (7.2) is directly coupled onto the central unit (3.1, 3.2, 3.3),
d) each of the baseboards (2.1, 2.2, 2.3) has a field bus connection interface (10) for a standard field bus connection (5) to a decentral input/output unit (6), **characterized in that**
the central unit (3.1, 3.2, 3.3) and the at least one input/output expansion device (7.2) are electrically connected without cable connections wirelessly via plug connections, and
**in that** the at least one input/output expansion device (7.2) of the decentral input/output unit (6) in each case features a terminal block (9.1, 9.2) onto which an I/O module (12.1, 12.2) is plugged in each case.

2. Automation system according to Claim 1, **characterized in that** the relevant baseboard (2.1, 2.2, 2.3) of the central automation device (1.1, 1.2, 1.3) can be clipped onto a standard DIN rail (8), wherein the at least one input/output device (7.2) can likewise be clipped onto the DIN rail (8) and electrically and mechanically plugged into the relevant baseboard (2.1, 2.2, 2.3).

3. Automation system according to one of the preceding claims, **characterized in that** each baseboard (2.1, 2.2, 2.3) can be equipped with at least one communication coupler (4) for bus connections.

4. Automation system according to one of the preceding claims, **characterized in that** decentral input/output units (6) in each case feature an input/output device (7.1) with a field bus connection interface (10), wherein at least one input/output expansion device (7.2) can be connected to the input/output device (7.1).

5. Automation system according to Claim 4, **characterized in that** the input/output device (7.1) is connected to an input/output expansion device (7.2), and input/output expansion devices (7.2) are connected to each other, via plug-type connections (11, 29) for carrying signals of an expansion bus.

6. Automation system according to one of the preceding claims, **characterized in that** all components (2.1, 2.2, 2.3, 3.1, 3.2, 3.3, 4, 7.2) of a decentral automation device (1.1, 1.2, 1.3) and all components (7.1, 7.2, 9.1, 9.2, 12.1, 12.2) of an input/output unit (6) can be or are electrically connected to each other without cables via plug-type connections.

7. Automation system according to Claim 6, **characterized in that** the components (2.1, 2.2, 2.3, 3.1, 3.2, 3.3, 4, 7.2) of the relevant automation device (1.1, 1.2, 1.3) and the components (7.1, 7.2, 9.1, 9.2, 12.1, 12.2) of the input/output unit (6) additionally can be or are in each case detachably connected to each other by means of plug-type means and/or snap-in means (11, 13, 14, 29, 28, 30).

## Revendications

1. Système d'automatisation modulaire, dans lequel
a) un appareil d'automatisation central (1.1, 1.2, 1.3) est construit en utilisant une parmi plusieurs cartes de base (2.1, 2.2, 2.3) extensibles différentes à sélectionner,
b) l'appareil d'automatisation (1.1, 1.2, 1.3) est construit en utilisant une parmi plusieurs unités centrales (3.1, 3.2, 3.3) qui, avec des dimensions extérieures harmonisées, présentent des puissances de traitement de données et des capacités de traitement de données différentes,
c) au moins un appareil d'extension d'entrée/sortie (7.2) est connecté directement à l'unité centrale (3.1, 3.2, 3.3), et
d) chacune des cartes de base (2.1, 2.2, 2.3) possède une borne de bus de terrain (10) pour une liaison de bus de terrain standard (5) vers une unité d'entrée/sortie (6) décentralisée, **caractérisé en ce que**
l'unité centrale (3.1, 3.2, 3.3) et l'au moins un appareil d'extension d'entrée/sortie (7.2) sont reliés électriquement sans fil sans aucune liaison par câble par le biais de connexions enfichables, et
que l'au moins un appareil d'extension d'entrée/sortie (7.2) de l'unité d'entrée/sortie (6) décentralisée présente à chaque fois un bornier (9.1, 9.2) sur lequel est à chaque fois enfiché un module d'E/S (12.1, 12.2).

2. Système d'automatisation selon la revendication 1, **caractérisé en ce que** la carte de base (2.1, 2.2, 2.3) correspondante de l'appareil d'automatisation central (1.1, 1.2, 1.3) peut être enclipsée sur un rail DIN normalisé (8), l'au moins un appareil d'entrée/sortie (7.2) pouvant lui aussi être enclipsé sur le rail DIN normalisé (8) et pouvant être assemblé électriquement et mécaniquement par enfichage avec la carte de base (2.1, 2.2, 2.3) correspondante.

3. Système d'automatisation selon l'une des revendications précédentes, **caractérisé en ce que** chaque carte de base (2.1, 2.2, 2.3) peut être équipée d'au moins un coupleur de communication (4) pour des liaisons de bus.

4. Système d'automatisation selon l'une des revendications précédentes, **caractérisé en ce que** les unités d'entrée/sortie (6) décentralisées présentent respectivement un appareil d'entrée/sortie (7.1) avec une borne de bus de terrain (10), au moins un appareil d'extension d'entrée/sortie (7.2) pouvant être raccordé à l'appareil d'entrée/sortie (7.1).

5. Système d'automatisation selon la revendication 4, **caractérisé en ce que** la liaison de l'appareil d'entrée/sortie (7.1) avec un appareil d'extension d'entrée/sortie (7.2) ainsi que d'appareils d'extension d'entrée/sortie (7.2) entre eux est réalisée au moyen de connexions enfichables (11, 29) destinées à la transmission des signaux d'un bus d'extension.

6. Système d'automatisation selon l'une des revendications précédentes, **caractérisé en ce que** tous les composants (2.1, 2.2, 2.3, 3.1, 3.2, 3.3, 4, 7.2) d'un appareil d'automatisation central (1.1, 1.2, 1.3) ainsi que tous les composants (7.1, 7.2, 9.1, 9.2, 12.1, 12.2) d'une unité d'entrée/sortie (6) peuvent être reliés ou sont reliés électriquement entre eux sans fil par le biais de connexions enfichables.

7. Système d'automatisation selon la revendication 6, **caractérisé en ce que** les composants (2.1, 2.2, 2.3, 3.1, 3.2, 3.3, 4, 7.2) de l'appareil d'automatisation (1.1, 1.2, 1.3) correspondant ainsi que les composants (7.1, 7.2, 9.1, 9.2, 12.1, 12.2) de l'unité d'entrée/sortie (6) peuvent en outre être reliés ou sont reliés entre eux de manière amovible respectivement à l'aide de moyens d'enfichage et/ou d'enclenchement (11, 13, 14, 29, 28, 30).
